# EUROPÄISCHE PATENTSCHRIFT

(11) **EP 3 807 662 B1**
(45) Veröffentlichungstag und Bekanntmachung des Hinweises auf die Patenterteilung: **20.04.2022**
(21) Anmeldenummer: 19706516.2
(22) Anmeldetag: 18.02.2019
(51) Int. Cl.: G01R 31/34

(54) **VERFAHREN UND VORRICHTUNG ZUR VERSCHLEISSÜBERWACHUNG EINES LANGSTATOR-LINEARMOTOR-SYSTEMS**
METHOD AND APPARATUS FOR MONITORING THE WEAR OF A LONG-STATOR LINEAR MOTOR SYSTEM
PROCÉDÉ ET DISPOSITIF DE CONTRÔLE D'USURE D'UN SYSTÈME DE MOTEUR LINÉAIRE À STATOR LONG

(30) Priorität: 15.06.2018 DE 102018209723
(43) Veröffentlichungstag der Anmeldung: 21.04.2021
(73) Patentinhaber: Krones AG, 93073 Neutraubling (DE)
(72) Erfinder: KIENDL, Thomas, 93073 Neutraubling (DE); DAVIDSON, Hartmut, 93073 Neutraubling (DE); ELSPERGER, Stefan, 93073 Neutraubling (DE)
(74) Vertreter: Grünecker Patent- und Rechtsanwälte PartG mbB
(86) Internationale Anmeldenummer: PCT/EP2019/053916
(87) Internationale Veröffentlichungsnummer: WO 2019/238276

(56) Entgegenhaltungen:
- JP-A- S64 440
- JP-A- H0 454 403
- US-A1- 2017 346 380

## Beschreibung

Die Erfindung betrifft ein Verfahren und eine Vorrichtung zur Verschleißüberwachung eines Langstator-Linearmotor-Systems gemäß Oberbegriff des Anspruchs 1 und 6 und wie bekannt aus US 2017/0346380 A1.

Transportsysteme mit Langstator-Linearmotoren und davon individuell angetriebenen Transportfahrzeugen (Shuttles) sowie dynamische Magnetweichen zur Verteilung der Transportfahrzeuge auf unterschiedliche Transportbahnen sind im Prinzip beispielsweise aus der DE 10 2013 218 389 bekannt.

Die Funktion der Magnetweichen beruht dabei auf dem Prinzip, dass Stromfluss durch die seitlich angeordneten Statoren im Weichenbereich eine in Querrichtung auf das jeweilige Fahrzeug / Shuttle wirkende Anziehungskraft bzw. eine abstoßende Kraft erzeugt und/oder eine anziehende Normalkraft reduziert. Diese kann gezielt verändert werden, um einzelne Fahrzeuge / Shuttles in die jeweils zugordnete Transportbahn zu leiten.

Für eine zuverlässige Weichenfunktion sind möglichst gleichmäßige Querkräfte, insbesondere Normalkräfte, wie beispielsweise durch Reluktanz erforderlich. Die Normalkräfte hängen von verschiedenen Parametern ab, wie der Breite des magnetischen Luftspalts und der Magnetisierung der magnetischen Reaktionselemente auf dem jeweiligen Transportfahrzeug.

Bedingt durch Herstellungstoleranzen und betriebsbedingten Verschleiß der Fahrzeuglaufrollen können sich unterschiedliche Luftspaltmaße auf beiden Seiten des antriebstechnisch symmetrisch aufgebauten Fahrzeugs / Shuttles ergeben. Problematisch ist dabei, dass symmetrische Spaltmaße für eine sichere Weichenfunktion von entscheidender Bedeutung sind. Asymmetrien von wenigen Zehntelmillimetern können bereits zu unkontrollierten Querkräften bzw. Normalkräften führen, die höher sind als die Stellkräfte der Weichen. Dies führt dann zu einer Fehlfunktion der Weiche. Auch der motorische Betrieb mit einseitig angebrachten Motorsegmenten wird verändert, da der Luftspalt die Motoreigenschaften, wie beispielsweise Kraftfaktor und Gegen-EMK beeinflusst.

Es besteht daher Bedarf für eine vorausschauende Verschleißüberwachung weichenfähiger Langstator-Linearmotor-Systeme insbesondere zur Vorbeugung von Weichenfehlfunktionen aber auch im normalen motorischen Betrieb. Anders gesagt sollen fehlerhafte Fahrzeuge / Shuttles, insbesondere solche mit verschlissenen Laufrollen, möglichst rechtzeitig erkannt und ersetzt bzw. repariert werden.

Die gestellte Aufgabe wird mit einem Verfahren gemäß Anspruch 1 gelöst. Demnach dient dieses der Verschleißüberwachung eines Langstator-Linearmotor-Systems umfassend wenigstens einen Motorstrang mit Statoren und wenigstens ein davon elektromagnetisch angetriebenes Transportfahrzeug. Erfindungsgemäß wird eine vom Transportfahrzeug quer zu dessen Transportrichtung elektromagnetisch und/oder mechanisch auf den Motorstrang ausgeübte Kraft oder eine vom Transportfahrzeug derart auf zwei gegenüberliegende Motorstränge ausgeübte Differenzkraft sensorisch gemessen.

Die Überwachung ist kontinuierlich im laufenden Betrieb bzw. Produktstrom möglich. Beispielsweise kann während des Betriebs eine Normalkraft zwischen Transportfahrzeug und Motorstrang mittels Kraftsensor fortlaufend gemessen und ausgewertet werden. Dies kann sowohl einseitig erfolgen, wobei dann die absolute Normalkraft gemessen wird, als auch beidseitig, wobei dann eine Differenz-Normalkraft ermittelt wird. Anschließend können die gemessenen Kräfte auf kritische Werte überprüft werden.

Mit der Zeit einseitig zunehmende Querkräfte deuten auf einen Verschleiß der Laufrollen des Transportfahrzeugs hin. Somit lässt sich eine drohende Fehlfunktion insbesondere aufgrund zu geringen Abstands des Transportfahrzeugs von einem Motorstrang vorhersagen.

Vorzugsweise ist die Kraft / Differenzkraft eine vom Transportfahrzeug elektromagnetisch auf einen Stator des Motorstrangs ausgeübte Querkraft, insbesondere eine Normalkraft. Dies lässt einen direkten Rückschluss über die Spaltweite zwischen Stator und magnetischem Reaktionselement des Transportfahrzeugs zu.

Vorzugsweise ist die Kraft eine vom Transportfahrzeug mechanisch auf eine Führungsschiene des Motorstrangs ausgeübte Querkraft, insbesondere eine Normalkraft. Die Querkraft wird dann von den Laufrollen des Transportfahrzeugs auf die Führungsschiene übertragen und lässt ebenso einen zuverlässigen Rückschluss über die Spaltweite zwischen Stator und magnetischem Reaktionselement des Transportfahrzeugs zu.

Erfindungsgemäß repräsentiert die gemessene Kraft / Differenzkraft einen Istwert und wird als solcher mit einem zulässigen Maximalwert verglichen. Dies ermöglicht eine laufende Abschätzung über die Wahrscheinlichkeit einer drohenden Fehlfunktion, gegebenenfalls auch eine Trendanalyse über die Wahrscheinlichkeit.

Erfindungsgemäß ist der zulässige Maximalwert kleiner als eine Mindestquerstellkraft einer am Langstator-Linearmotor-System ausgebildeten Weiche für das Transportfahrzeug. Damit lässt sich eine drohende Fehlfunktion der Weiche vorhersagen mit dem Ziel, fehlerhafte Transportfahrzeuge rechtzeitig zu ersetzen und/oder zu reparieren. Vorzugsweise wird maschinell überprüft, ob die gemessene Kraft / Differenzkraft in einem zwischen einem zulässigen Maximalwert und einem zulässigen Minimalwert definierten zulässigen Arbeitsbereich des Motorensystems liegt. Beispielsweise vergleicht eine dem Langstator-Motorsystem zugeordnete Recheneinheit wenigstens einen gemessenen Istwert mit einem dem zulässigen Arbeitsbereich entsprechend vorgegebenen Sollwertbereich.

Anders gesagt soll die gemessene Kraft / Differenzkraft für den ordnungsgemäßen Betrieb des Langstator-Motorsystems einen zulässigen Messwert ergeben, der zwischen einer vorher festgelegten oberen und unteren Grenze liegt. Dies ermöglicht einen dauerhaft ordnungsgemäßen Betrieb des Motorensystems auch ohne Weiche.

Vorzugsweise ist die gemessene Kraft / Differenzkraft ein Maß für die Breite eines Abstands, insbesondere Spalts, zwischen einem Stator des Motorstrangs im Bereich der Kraftmessung und einem magnetischen Reaktionselement des Transportfahrzeugs. Damit ist ein Rückschluss über den Verschleiß der Laufrollen möglich.

Die gestellte Aufgabe wird ebenso mit einer Vorrichtung gemäß Anspruch 6 gelöst. Demnach dient diese zur Verschleißüberwachung eines Langstator-Linearmotor-Systems und umfasst wenigstens einen Motorstrang mit Statoren und wenigstens ein von diesem elektromagnetisch angetriebenen Transportfahrzeug. Erfindungsgemäß umfasst die Vorrichtung ferner eine insbesondere am Motorstrang befestigte Messeinrichtung zur Messung einer vom Transportfahrzeug quer zu dessen Transportrichtung auf den Motorstrang ausgeübten Kraft. Es werden dieselben Vorteile erzielt wie mit dem erfindungsgemäßen Verfahren.

Vorzugsweise umfasst der Motorstrang einen Rahmen und wenigstens einen daran gelagerten Stator, und die Messeinrichtung umfasst wenigstens eine Kraftmessdose, die zwischen dem Stator und dem Rahmen zur Messung einer auf den Stator wirkenden elektromagnetischen Anziehungskraft angeordnet ist. Dies ermöglicht eine einfache Kraftmessung durch Auseinanderziehen der Kraftmessdose zwischen Stator und Rahmen oder dergleichen.

Vorzugsweise umfasst der Motorstrang einen Rahmen und eine daran gelagerte Führungsschiene, das Transportfahrzeug umfasst daran seitlich entlanglaufende Laufrollen, und die Messeinrichtung umfasst wenigstens eine Kraftmessdose, die zwischen der Führungsschiene und dem Rahmen zur Messung einer auf die Führungsschiene wirkenden Andrucckraft angeordnet ist. Dies ermöglicht unterschiedliche Kraftmessungen durch Zusammendrücken, Auseinanderziehen oder Verschieben von Befestigungselementen der Kraftmessdose zwischen Führungsschiene und Rahmen.

Vorzugsweise umfasst die Messeinrichtung wenigstens eine zwischen einem Rahmen des Motorstrangs und einem Stator und/oder zwischen dem Rahmen und einer seitlichen Führungsschiene für das Transportfahrzeug kraftschlüssig eingesetzte Kraftmessdose. Kraftmessdosen sind zuverlässig und wirtschaftlich für eine dauerhafte Überwachung im Produktionsbetrieb.

Vorzugsweise sind zwei Motorstränge mit einer Messeinrichtung zu beiden Seiten des Transportfahrzeugs ausgebildet, um eine vom Transportfahrzeug quer zu seiner Transportrichtung auf die Motorstränge ausgeübten Differenzkraft zu messen. Dies ist besonders aufschlussreich für eine Überwachung der Eingangsbereiche von Weichen.

Erfindungsgemäß liegt der Motorstrang im Eingangsbereich zu einer Weiche des Langstator-Linearmotor-Systems. In diesem Bereich befinden sich beidseitig vom Transportfahrzeug Motorstränge, deren ausgeübte Querkraft entscheidend für die korrekte Schaltfunktion der Weiche ist. Somit lässt sich die Funktionstüchtigkeit der Weiche zuverlässig abschätzen.

Vorzugsweise ist die Messeinrichtung in einem geradlinigen Abschnitt des Motorstrangs angeordnet. Dort treten im Idealfall symmetrische Querkräfte zu beiden Seiten des Transportfahrzeugs auf, und somit eine Differenz-Normalkraft im Idealfall gleich null. Eine Überwachung ist dort besonders einfach und aufschlussreich.

Vorzugsweise ist die Messeinrichtung zur Messung einer seitlichen Normalkraft ausgebildet. Dies vereinfacht eine zuverlässige Abschätzung der Spaltweite und Vorhersage der Weichenfunktion durch Vergleich mit der zugehörigen Stellkraft.

Erfindungsgemäß umfasst die Vorrichtung ferner eine Recheneinheit zum Vergleich eines mit der Messeinrichtung gemessenen Istwerts mit einem Sollwert oder Sollwertbereich, insbesondere mit einem zulässigen Maximalwert, einer quer zur Transportrichtung auf den Motorstrang wirkenden Kraft und/oder einer auf einander gegenüberliegende Motorstränge wirkenden Differenzkraft. Dadurch sind vielfältige Auswertungen sowohl hinsichtlich des Istzustands als auch darauf basierende Trendanalysen möglich.

Bevorzugte Ausführungsformen der Erfindung sind zeichnerisch dargestellt. Es zeigen:
Fig. 1 einen Blick in eine Weiche des Langstator-Linearmotor-Systems;
Fig. 2 eine Draufsicht auf den Eingangsbereich der Weiche;
Fig. 3 einen schematischen Querschnitt durch ein Langstator-Linearmotor-System zur Verdeutlichung der zugrundeliegenden Problemstellung.
Fig. 4 einen schematischen Querschnitt durch eine erste Ausführungsform der Messeinrichtung;
Fig. 5 einen schematischen Querschnitt durch eine zweite Ausführungsform der Messeinrichtung;
Fig. 6 einen schematischen Querschnitt durch eine dritte Ausführungsform der Messeinrichtung; und
Fig. 7 einen schematischen Schnitt durch die dritte Ausführungsform von oben gesehen.

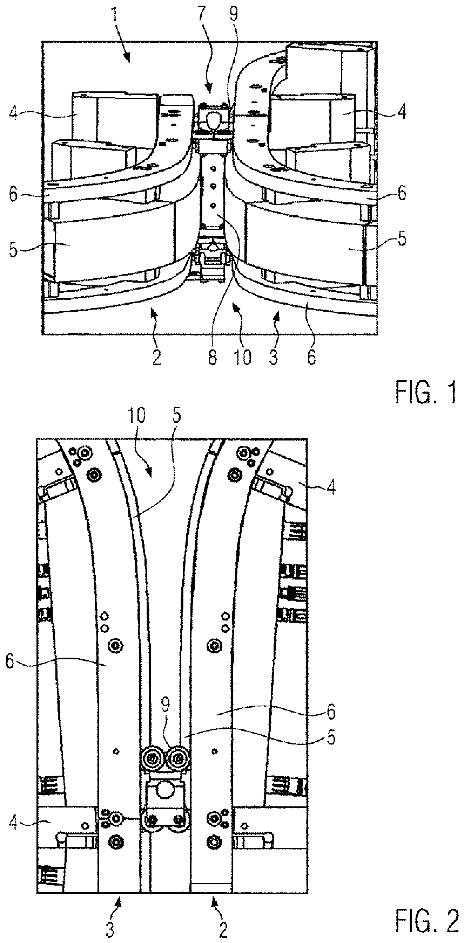

Die Fig. 1 und 2 zeigen einen Abschnitt eines Langstator-Linearmotor-Systems 1 mit einander gegenüberliegenden Motorsträngen 2, 3, die jeweils einen Rahmen 4 und daran befestigte elektromagnetische Statoren 5 sowie seitliche Führungsschienen 6 für ein Transportfahrzeug 7 (Shuttle) umfassen. Das Transportfahrzeug 7 umfasst mit den Statoren 5 wechselwirkende magnetische Reaktionselemente 8 sowie an den Führungsschienen 6 entlanglaufende Laufrollen 9. Diese Komponenten von Langstator-Linearmotor-Systemen 1 dienen zum Transport von Behältern oder dergleichen Produktkomponenten in Abfüllanlagen, sind an sich bekannt und daher im Folgenden nicht weiter erläutert.

In den Fig. 1 und 2 ist ferner eine Weiche 10 zu erkennen, hinter der sich die Transportbahn für das Transportfahrzeug 7 entweder entlang des einen Motorstrangs 2 oder des anderen Motorstrangs 3 fortsetzt. Bei geeignetem Stromfluss durch die Statoren 5 des jeweils aktivierten Motorstrangs 2 oder 3 wird das Transportfahrzeug 7 so fest seitlich angezogen, dass es auch nach der Weiche 10 weiterhin an dem aktivierten Motorstrang 2, 3 entlanggeführt wird. Auch dies ist an sich bekannt.

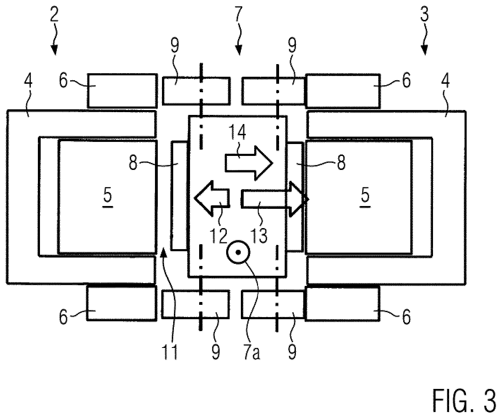

Wie die Fig. 3 im Prinzip verdeutlicht, wirkt je nach Weite eines zwischen Stator 5 und magnetischem Reaktionselement 8 jeweils wirksamen Luftspalts 11 eine anziehende Kraft 12, 13 zwischen Transportfahrzeug 7 und jeweiligem Motorstrang 2, 3. Je weiter der Luftspalt 11, desto kleiner die Kraft 12, 13 und umgekehrt. Die einander entgegengesetzten Kräfte 12, 13 können absolut gemessen werden und resultieren in einer daraus berechenbaren Differenzkraft 14.

Die Kräfte 12, 13, 14 sind Querkräfte und insbesondere Normalkräfte bezogen auf die Transportrichtung 7a des Transportfahrzeugs 7.

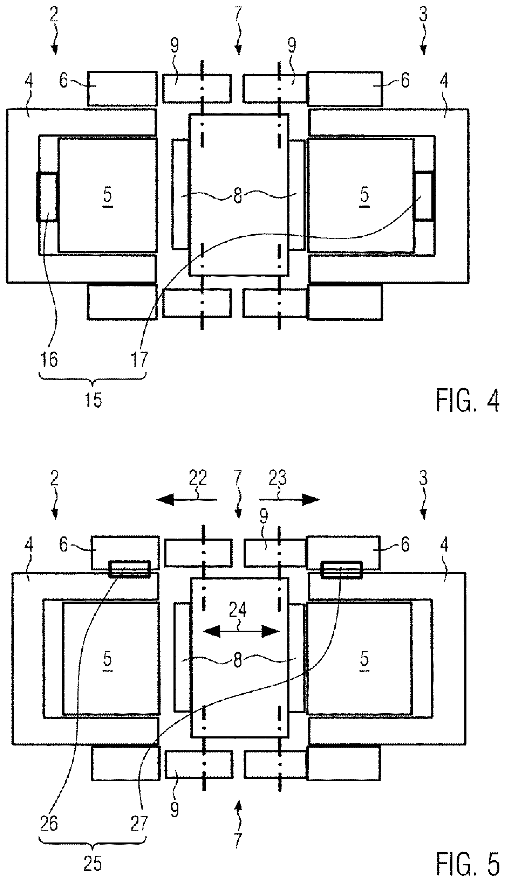

Die Ausführungsform gemäß Fig. 4 umfasst eine Messeinrichtung 15 mit einer ersten Kraftmessdose 16 zur Messung der Kraft 12 und/oder mit einer zweiten Kraftmessdose 17 zur Messung der entgegengesetzten Kraft 13. Die Kraftmessdosen 16, 17 sind jeweils am Rahmen 4 und am Stator 5, insbesondere dazwischenliegend, des zugeordneten Motorstrangs 2, 3 befestigt. Die Kraftmessdosen 16, 17 messen dann Zugkräfte zwischen den Rahmen 4 und den Statoren 5. Anders gesagt ist der Stator 5 dann vorzugsweise mittels der Kraftmessdosen 16, 17 am Rahmen 4 befestigt.

Die Messeinrichtung 15 detektiert vorzugsweise die Differenzkraft 14 die auf die Motorstränge 2,3 wirkt. Diese Variante der Messung ist im Parallelfahrbereich vor der Weiche 10 und/oder innerhalb eines speziellen Überwachungssegments mit beiderseits geradlinigen Motorsträngen 2, 3 möglich. Eine einseitige Messung der Kraft 12, 13 ist auch an einem freistehenden bzw. einseitigen Segment des Langstator-Linearmotor-Systems 1 möglich.

Die Ausführungsform gemäß Fig. 5 dient der Messung einer Kraft 22, 23, mit der die Laufrollen 9 gegen die zugeordnete Führungsschiene 6 drückt. Die Kraft 22, 23 wirkt in Normalkraftrichtung 24 zwischen dem Transportfahrzeug 7 und dem jeweiligen Motorstrang 2, 3.

Hierzu ist eine Messeinrichtung 25 mit einer ersten Kraftmessdose 26 zur Messung der Kraft 22 und/oder mit einer zweiten Kraftmessdose 27 zur Messung der entgegengesetzten Kraft 23 vorhanden. Die Kraftmessdosen 26, 27 sind jeweils am Rahmen 4 und an der Führungsschiene 6, insbesondere dazwischenliegend, des zugeordneten Motorstrangs 2, 3 befestigt und messen beispielsweise eine Schubkraft bzw. Andruckkraft zwischen Rahmen 4 und Führungsschiene 6. Darunter ist zu verstehen, dass eine Normalkraft auf die Führungsschiene 6 gemessen wird, die so gerichtet ist, als ob die Führungsschiene 6 weggeschoben würde.

Die Messeinrichtung 25 detektiert dann vorzugsweise die direkt in Normalkraftrichtung 24 auf die jeweilige Führungsschiene 6 einwirkende Kraft 22 oder 23. Eine Differenzmessung ist dann nicht erforderlich. Diese Variante der Messung ist im Parallelfahrbereich vor der Weiche 10 und/oder innerhalb eines speziellen Überwachungssegments mit beiderseits geradlinigen Motorsträngen 2, 3 möglich. Eine einseitige Messung der Kraft 22, 23 ist auch an einem freistehenden Segment des Langstator-Linearmotor-Systems 1 möglich.

Aus den gemessenen Kräften 12, 13, 14, 22, 23 lässt sich auf einen fortschreitenden und/oder kritischen Verschleiß der Laufrollen 9 oder auf anderweitige Abweichungen vom Sollzustand des Langstator-Linearmotor-Systems 1 schließen.

Die Erfindung erlaubt somit eine unmittelbare Darstellung der aktuellen Kraftsituation zwischen Transportfahrzeugen 7 und Motorsträngen 2, 3, was für eine zuverlässige Vorhersage von Weichenfunktionen ausgehend von deren auslösenden Stellkräften entscheidend ist.

Folglich ermöglicht die vorliegende Erfindung eine erhöhte Prozesssicherheit der Weichen 10 und eine Reduzierung spontan auftretender Fehlerzustände des Transportsystems insgesamt. Transportfahrzeuge 7 und/oder einzelne Bauteile, insbesondere deren Laufrollen 9, können bedarfsgerecht und damit auf wirtschaftliche Weise ausgewechselt werden.

Funktionskritische Transportfahrzeuge 7 können erkannt und anschließend manuell ausgetauscht werden. Möglich ist auch eine automatisierte Variante, bei der funktionskritische Transportfahrzeuge 7 mittels Weiche ausgeschleust und überholte oder neue Transportfahrzeuge 7 als Ersatz eingeschleust werden.

Weitere, nicht erfindungsgemäße Möglichkeiten der Verschleißüberwachung sind nachfolgend beschrieben.

Als Indiz für einen Rollenverschleiß können beispielsweise Schwingungen gemessen werden, die das Transportfahrzeug auf die Führungsschienen überträgt. Denkbar ist hierbei auch eine einseitige Variante. Es sind dann beispielsweise Schwingungssensoren (nicht dargestellt) an den Führungsschienen angebracht. Da Rollenverschleiß am Transportfahrzeug die Führungsschienen zu definierten Schwingungen anregt, können diese von den Schwingungssensoren aufgenommen werden. Mit einer digitalen Auswertung der Schwingungen bezüglich Frequenzbereich und Amplitude kann der Verschleiß der Rollen somit überwacht werden.

Möglich ist ebenso eine Messung des Rollenverschleißes, auf deren Grundlage man auf eine geänderte Kraftsituation zwischen den Transportfahrzeugen und Motorsträngen schließen kann.

Alternativ ist auch eine direkte Messung des Luftspalts zwischen Stator und magnetischem Reaktionselement des Fahrzeugs als Maß für die resultierende Normalkraft denkbar, beispielsweise mittels einer Laufwegmessung mit Ultraschall, Laserlicht oder dergleichen.

In Kombination mit wenigstens einer voranstehend beschriebenen Ausführungsform der vorliegenden Erfindung oder auch für sich allein genommen ist ein weiteres Überwachungsverfahren zur Verschleißkontrolle eines Langstator-Linearmotor-Systems anwendbar, das auf einer Messung induzierter Spannungen beruht.

Ein solches Verfahren dient zur Verschleißüberwachung eines Langstator-Linearmotor-Systems mit wenigstens einem Motorstrang mit Statoren und wenigstens einem elektromagnetisch davon angetriebenen Transportfahrzeug.

Ferner wird eine von dem sich bewegenden Transportfahrzeug mittels daran ausgebildeter magnetischer Reaktionselemente in wenigstens einer Spulenwicklung der Statoren induzierte Spannung gemessen.

Die Höhe dieser Spannung ist abhängig von der Weite des zwischen Stator und magnetischem Reaktionselement jeweils wirksamen Luftspalts. Je weiter der Luftspalt, desto kleiner die derart gemessene Spannung und umgekehrt.

Aus der gemessenen Spannung lässt sich unter Berücksichtigung anderer, die gemessene Spannung beeinflussender Parameter, wie insbesondere der Relativgeschwindigkeit der Reaktionselemente bezüglich der Statoren und/oder der magnetischen Feldstärke der Reaktionselemente, auf die Weite des Luftspalts schließen.

Das Unterschreiten einer vorgegebenen Mindestweite und/oder ein bestimmter zeitlicher Verlauf einer zunehmenden Verengung des Luftspalts können dann als Beurteilungskriterium für einen Verschleiß des Langstator-Linearmotor-Systems verwendet werden.

Die induzierte Spannung kann durch die Motorelektronik des Langstator-Linearmotor-Systems gemessen und ausgewertet werden.

Die Geschwindigkeit des Transportfahrzeugs kann durch separate Positionserkennung beispielsweise von einem unabhängigen Sensorsystem erfasst werden. Im Normalfall werden die intern verbauten Positionssensoren für die Positionserkennung verwendet. Daraus ergibt sich die Möglichkeit, die Geschwindigkeit als beeinflussende Größe der Spannungsmessung zu kompensieren und nur die für die Verschleißüberwachung relevanten Parameter zu detektieren.

Die gemessene Spannung bzw. eine daraus berechenbare Größe der Normalkraft kann anschließend mit kritischen Werten verglichen werden.

Eine entsprechende Vorrichtung zur Verschleißüberwachung eines Langstator-Linearmotor-Systems umfasst einen Motorstrang mit Statoren und wenigstens einem von diesem elektromagnetisch angetriebenen Transportfahrzeug. Ferner ist eine Messeinrichtung zur Messung einer von dem sich bewegenden Transportfahrzeug mittels daran ausgebildeter magnetischer Reaktionselemente in wenigstens einer Spulenwicklung der Statoren induzierten Spannung vorhanden.

Die Vorrichtung umfasst dann beispielsweise eine Recheneinheit zur Auswertung der gemessenen Spannungen wie oben bezüglich des Verfahrens beschrieben ist.

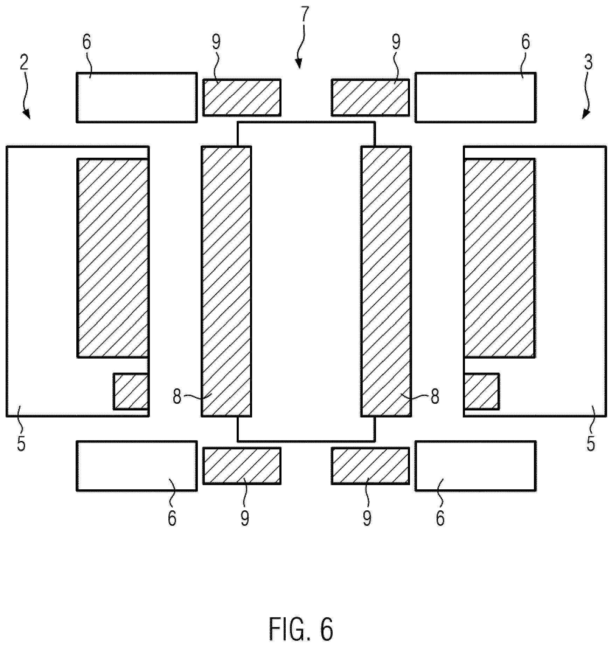

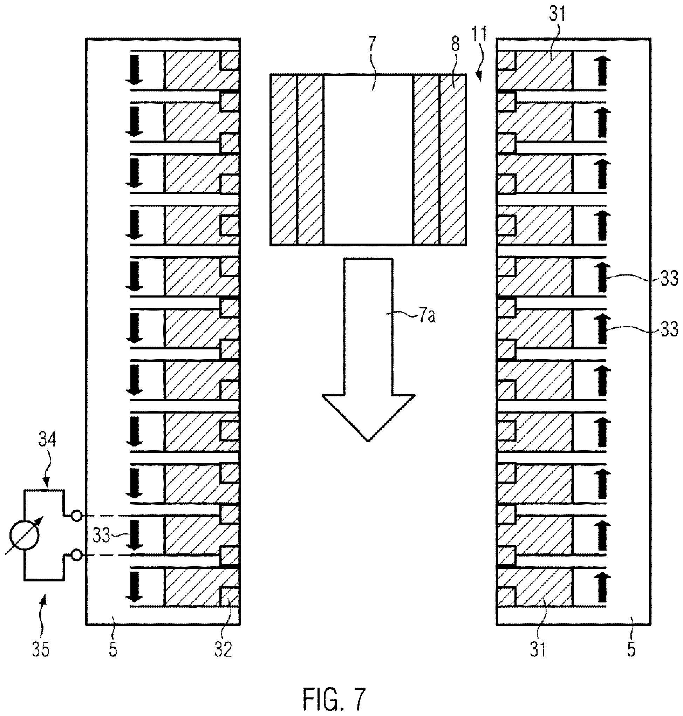

Die Fig. 6 und 7 zeigen einen schematisch einen Abschnitt des Langstator-Linearmotor-Systems 1 mit einer dritten Ausführungsform einer Messeinrichtung zur Verschleißüberwachung der Laufrollen auf Grundlage der oben genannten Spannungsmessung.

Die einander gegenüberliegenden Motorstränge 2, 3, sind an einem (nicht dargestellten) Rahmen befestigt und umfassen die elektromagnetischen Statoren 5 sowie die seitlichen Führungsschienen 6 für Transportfahrzeuge 7 (Shuttles). Die Transportfahrzeuge 7 umfassen jeweils mit den Statoren 5 wechselwirkende magnetische Reaktionselemente 8, vorzugsweise Permanentmagnete, sowie an den Führungsschienen 6 entlanglaufende Laufrollen 9, wie bereits für die anderen Ausführungsformen beschrieben wurde.

Die Statoren 5 umfassen in prinzipiell bekannter Weise eine Vielzahl in Transportrichtung 7a aneinander gereihter elektromagnetischer Spulen 31. Ferner ist im Bereich der Statoren 5 eine Vielzahl in Transportrichtung 7a aneinander gereihter Positionssensoren 32 vorhanden. Zur sukzessiven Messung einer in einzelnen Spulen 31 induzierten elektrischen Spannung 33 und/oder eines demzufolge fließenden elektrischen Stroms 34 ist ferner eine Messeinrichtung 35 vorhanden, die lediglich schematisch angedeutet ist.

Damit lässt sich eine Verschleißüberwachung des Langstator-Linearmotor-Systems 1 beispielsweise wie folgt durchführen.

Die magnetischen Reaktionselemente 8 (Permanentmagnete) des Transportfahrzeugs 7 induzieren abhängig von der aktuellen Geschwindigkeit des jeweiligen Transportfahrzeugs 7 eine Spannung 33 in den einzelnen Spulen 31.

Die Höhe der so induzierten Spannung 33 ist unter anderem abhängig von Stärke der Reaktionselemente 8 (Permanentmagnete), der Geschwindigkeit des Transportfahrzeugs 7 und vom Luftspalt 11 zwischen jeweiliger Spule 31 und Transportfahrzeug 7.

Die Spulen 31 können hierbei gleichzeitig zum Antrieb des Transportfahrzeugs 7 verwendet werden.

An den Kontakten der Spulen 31 kann induzierte Spannung 33 und/oder induzierter Strom 34 gemessen werden.

Durch Auslesen der Positionssensoren 32 kann die aktuelle Position und Geschwindigkeit des Transportfahrzeugs 7 ermittelt werden.

Aus derartiger Positions- und/oder Geschwindigkeitsinformation und dem Steuerverhalten der dem Stator zugeordneten Steuerelektronik kann eine nominell induzierte Spannung für unterschiedlich weite Luftspalte 11 berechnet werden.

Für die Berechnung der nominell induzierten Spannung können prinzipiell bekannte Verfahren verwendet werden, wie sie beispielsweise für Umrichtern angewendet werden.

Durch Vergleich berechneter und gemessener Spannungen 33 kann dann die Weite des tatsächlich vorhandenen Luftspalts 11 bestimmt werden.

Hierfür gegebenenfalls nötige Information zu elektromagnetischen Eigenschaften des Langstator-Linearmotor-Systems 1, wie beispielsweise der Stärke der der Reaktionselemente 8 (Permanentmagnete), ist anhand üblicher Gerätedaten verfügbar.

Möglich ist sowohl ein Verfahren zur absoluten induktiven Vermessung des Luftspalts 11 als auch ein Verfahren, dass die relative Veränderung der Weite des Luftspalts 11 ausgehend von einem Startwert überwacht.

Alternativ oder ergänzend zu den voranstehend beschriebenen Verfahren sind auch vorgegebene Testzyklen mit definiert reduzierten Weichenstellkräften denkbar. Das Langstator-Linearmotor-System führt dann nach jedem Einschalten der Anlage oder in regelmäßigen Abständen automatisiert einen Testlauf ohne Produkt und unter definierten Bedingungen durch. Hierbei erfolgt eine Weichenauslösung mit reduzierten Weichenstellkräften, wobei kritische Transportfahrzeuge durch Fehlauslösung erkannt und manuell getauscht oder automatisiert ausgeschleust werden können.

## Patentansprüche

1. Verfahren zur Verschleißüberwachung eines Langstator-Linearmotor-Systems (1) mit wenigstens einem Motorstrang (2, 3) mit Statoren (5) und mit wenigstens einem elektromagnetisch davon angetriebenen Transportfahrzeug (7), **dadurch gekennzeichnet, dass** eine vom Transportfahrzeug (7) quer zu dessen Transportrichtung (7a) elektromagnetisch und/oder mechanisch auf den Motorstrang (2, 3) ausgeübte Kraft (12,13, 22, 23) oder eine vom Transportfahrzeug (7) auf zwei gegenüberliegende Motorstränge (2, 3) derart ausgeübte Differenzkraft (14) sensorisch gemessen wird, die gemessene Kraft (12, 13, 22, 23) / Differenzkraft (14) mit einem zulässigen Maximalwert verglichen wird, der kleiner ist als eine Mindestquerstellkraft einer am Langstator-Linearmotor-System (1) ausgebildeten Weiche (10) für das Transportfahrzeug (7).

2. Verfahren nach Anspruch 1, wobei die Kraft (12, 13) / Differenzkraft (14) eine vom Transportfahrzeug (7) elektromagnetisch auf einen Stator (5) des Motorstrangs (2, 3) ausgeübte Querkraft, insbesondere Normalkraft, ist.

3. Verfahren nach Anspruch 1 oder 2, wobei die Kraft (22, 23) eine vom Transportfahrzeug (7) mechanisch auf eine Führungsschiene (6) des Motorstrangs (2, 3) ausgeübte Querkraft, insbesondere Ist-Normalkraft ist.

4. Verfahren nach einem der vorigen Ansprüche, wobei überprüft wird, ob die gemessene Kraft (12, 13, 22, 23) / Differenzkraft (14) in einem zwischen einem zulässigen Maximalwert und einem zulässigen Minimalwert definierten zulässigen Arbeitsbereich des Langstator-Linearmotor-Systems (1) liegt.

5. Verfahren nach einem der Ansprüche, wobei die gemessene Kraft (12, 13, 22, 23) / Differenzkraft (14) ein Maß ist für die Breite eines Abstands, insbesondere Spalts (11), zwischen einem Stator (5) des Motorstrangs (2, 3) im Bereich der Kraftmessung und einem magnetischen Reaktionselement (8) des Transportfahrzeugs (8).

6. Vorrichtung zur Verschleißüberwachung eines Langstator-Linearmotor-Systems (1), wobei die Vorrichtung wenigstens einen Motorstrang (2, 3) mit Statoren (5) und mit wenigstens einem davon elektromagnetisch angetriebenen Transportfahrzeug (7) umfasst, **gekennzeichnet durch** eine am Motorstrang (2, 3) befestigte Messeinrichtung (15, 25) zur Messung einer vom Transportfahrzeug (7) quer zu dessen Transportrichtung (7a) auf den Motorstrang (2, 3) ausgeübten Kraft (12, 13, 14, 22, 23), und eine Recheneinheit zum Vergleich eines mit der Messeinrichtung (15, 25) gemessenen Istwerts mit einem zulässigen Maximalwert einer quer zur Transportrichtung (7a) auf den Motorstrang (2, 3) wirkenden Kraft (12, 13, 22, 23) / einer auf die Motorstränge (2, 3) wirkenden Differenzkraft (14), wobei der Motorstrang (2, 3) im Eingangsbereich zu einer Weiche (10) des Langstator-Linearmotor-Systems (1) angeordnet ist.

7. Vorrichtung nach Anspruch 6, wobei der Motorstrang (2, 3) einen Rahmen (4) und wenigstens einen daran gelagerten Stator (5) umfasst, wobei die Messeinrichtung (15) wenigstens eine Kraftmessdose (16, 17) umfasst, die am Stator (5) und am Rahmen (4) zur Messung einer auf den Stator (5) wirkenden elektromagnetischen Anziehungskraft angeordnet ist.

8. Vorrichtung nach Anspruch 6 oder 7, wobei der Motorstrang (2, 3) einen Rahmen (4) und eine daran gelagerte Führungsschiene (6) umfasst und das Transportfahrzeug (7) daran seitlich entlanglaufende Laufrollen (9) umfasst, und wobei die Messeinrichtung (25) wenigstens eine Kraftmessdose (26, 27) umfasst, die zwischen der Führungsschiene (6) und dem Rahmen (4) zur Messung einer auf die Führungsschiene (6) wirkenden Andruckkraft angeordnet ist.

9. Vorrichtung nach einem der Ansprüche 6 bis 8, wobei die Messeinrichtung (15, 25) wenigstens eine zwischen einem Rahmen (4) des Motorstrangs (2, 3) und einem Stator (5) und/oder zwischen dem Rahmen (4) und einer seitlichen Führungsschiene (6) für das Transportfahrzeug (7) kraftschlüssig eingesetzte Kraftmessdose (16, 17, 26, 27) umfasst.

10. Vorrichtung nach einem der Ansprüche 6 bis 9, wobei zwei Motorstränge (2, 3) mit einer Messeinrichtung (15, 25) beidseitig des Transportfahrzeugs (7) zur Messung von zwei vom Transportfahrzeug (7) quer zu seiner Transportrichtung (7a) auf die Motorstränge (2, 3) entgegengesetzt ausgeübten Kräften (12, 13, 22, 23) oder einer daraus resultierenden Differenzkraft (14) ausgebildet sind.

11. Vorrichtung nach wenigstens einem der Ansprüche 6 bis 10, wobei die Messeinrichtung (15, 25) in einem geradlinigen Abschnitt des Motorstrangs (2, 3) angeordnet ist.

12. Vorrichtung nach wenigstens einem der Ansprüche 6 bis 11, wobei die Messeinrichtung (15, 25) zur Messung einer seitlichen Normalkraft ausgebildet ist.

## Claims

1. Method for monitoring the wear of a long stator linear motor system (1) with at least one motor train (2, 3) with stators (5) and at least one transport vehicle (7) that is driven electromagnetically thereby, **characterized in that** a force (12, 13, 22, 23) exerted electromagnetically and/or mechanically upon said motor train (2, 3) by said transport vehicle (7) transverse to the latter's direction of transport (7a) or a differential force (14) exerted in such manner by said transport vehicle (7) upon two oppositely disposed motor trains (2, 3) is measured by sensors, where the measured force (12, 13, 22, 23) / differential force (14) is compared to a permissible maximum value that is smaller than a minimum transverse actuating force of a track switch (10) formed on said long stator linear motor system (1) for said transport vehicle (7).

2. Method according to claim 1, where said force (12, 13) / differential force (14) is a transverse force, in particular a normal force, exerted electromagnetically by said transport vehicle (7) upon a stator (5) of said motor train (2, 3).

3. Method according to claim 1 or 2, where said force (22, 23) is a transverse force, in particular an actual normal force, exerted mechanically by said transport vehicle (7) upon a guide rail (6) of said motor train (2, 3).

4. Method according to one of the preceding claims, where it is examined whether said measured force (12, 13, 22, 23) / differential force (14) is within a permissible working range of said long stator linear motor system (2) defined between a permissible maximum value and a permissible minimum value.

5. Method according to one of the claims, where said measured force (12, 13, 22, 23) / differential force (14) is a measure of the width of a distance, in particular a gap (11), between a stator (5) of said motor train (2, 3) in the region of the force measurement and a magnetic reaction element (8) of said transport vehicle (8).

6. Apparatus for monitoring the wear of a long stator linear motor system (1), comprising at least one motor train (2, 3) with stators (5) and at least one transport vehicle (7) which is electromagnetically driven thereby, **characterized by** a measuring device (15, 25) attached to said motor train (2, 3) for measuring a force (12, 13, 14, 22, 23) exerted upon said motor train (2, 3) by said transport vehicle (7) transverse to the latter's direction of transport (7a), and a processing unit for comparing an actual value measured with said measuring device (15, 25) to a permissible maximum value of a force (12, 13, 22, 23) acting transverse to said direction of transport (7a) upon said motor train (2, 3) / a differential force (14) acting upon said motor trains (2, 3), where said motor train (2, 3) is located in the entry region to a track switch (10) of said long stator linear motor system (1).

7. Apparatus according to claim 6, where said motor train (2, 3) comprises a frame (4) and at least one stator (5) mounted thereon, where said measuring device (15) comprises at least one load cell (16, 17) which is arranged on said stator (5) and on said frame (5) for measuring an electromagnetic pull force acting upon said stator (5).

8. Apparatus according to claim 6 or 7, where said motor train (2, 3) comprises a frame (4) and a guide rail (6) mounted thereon and said transport vehicle (7) comprises rollers (9) running laterally therealong, and where said measuring device (25) comprises at least one load cell (26, 27) which is arranged between said guide rail (6) and said frame (4) for measuring a pressing force acting upon said guide rail (6).

9. Apparatus according to one of the claims 6 to 8, where said measuring device (15, 25) comprises at least one load cell (16, 17, 26, 27) inserted in a force-fit manner between a frame (4) of said motor train (2, 3) and a stator (5) and/or between said frame (4) and a lateral guide rail (6) for said transport vehicle (7).

10. Apparatus according to one of the claims 6 to 9, where two motor trains (2, 3) are formed with a measuring device (15, 25) on either side of said transport vehicle (7) for measuring two forces (12, 13, 22, 23) exerted upon said motor trains (2, 3) in the opposite direction by said transport vehicle (7) transverse to the latter's transport direction (7a) or a differential force (14) arising therefrom.

11. Apparatus according to at least one of the claims 6 to 10, where said measuring device (15, 25) is arranged in a rectilinear section of said motor train (2, 3).

12. Apparatus according to at least one of the claims 6 to 11, where said measuring device (15, 25) is configured to measure a lateral normal force.

## Revendications

1. Procédé de contrôle d'usure d'un système de moteur linéaire à stator long (1) avec au moins une ligne de moteur (2, 3), des stators (5), et au moins un véhicule de transport (7) qu'il entraîne électromagnétiquement, **caractérisé en ce qu'**une force (12, 13, 22, 23) exercée électromagnétiquement et/ou mécaniquement sur la ligne de moteur (2, 3) par le véhicule de transport (7) transversalement à sa direction de transport (7a) ou une force différentielle (14) ainsi exercée par le véhicule de transport (7) sur deux lignes de moteur (2, 3) opposées est mesurée par un capteur, la force (12, 13, 22, 23) / force différentielle (14) mesurée étant comparée à une valeur maximale autorisée, qui est inférieure à une force d'actionnement transversale minimale d'un aiguillage (10) pour le véhicule de transport (7) pourvu sur le système de moteur linéaire à stator long (1).

2. Procédé selon la revendication 1, dans lequel la force (12, 13) / force différentielle (14) est une force transversale, en particulier une force normale, exercée électromagnétiquement par le véhicule de transport (7) sur un stator (5) de la ligne de moteur (2, 3).

3. Procédé selon la revendication 1 ou 2, dans lequel la force (22, 23) est une force transversale, en particulier une force normale, exercée mécaniquement par le véhicule de transport (7) sur un rail de guidage (6) de la ligne de moteur (2, 3).

4. Procédé selon l'une des revendications précédentes, dans lequel il est vérifié si la force (12, 13, 22, 23) / force différentielle (14) mesurée est comprise dans une plage de travail autorisée du système de moteur linéaire à stator long (1) définie entre une valeur maximale autorisée et une valeur minimale autorisée.

5. Procédé selon l'une des revendications précédentes, dans lequel la force (12, 13, 22, 23) / force différentielle (14) mesurée est une mesure de la largeur d'un espacement, en particulier d'un intervalle (11), entre un stator (5) de la ligne de moteur (2, 3) dans la plage de la mesure de force et un élément de réaction magnétique (8) du véhicule de transport (8).

6. Dispositif de contrôle d'usure d'un système de moteur linéaire à stator long (1), dans lequel le dispositif comporte au moins une ligne de moteur (2, 3) avec des stators (5) et au mois un véhicule de transport (7) qu'elle entraîne électromagnétiquement, **caractérisé par** un dispositif de mesure (15, 25) fixé sur la ligne de moteur (2, 3) pour la mesure d'une force (12, 13, 14, 22, 23) exercée par le véhicule de transport (7) transversalement à sa direction de transport (7a) sur la ligne de moteur (2, 3), et une unité de calcul pour la comparaison d'une valeur réelle mesurée par le dispositif de mesure (15, 25) à une valeur maximale autorisée d'une force (12, 13, 22, 23) exercée transversalement à la direction de transport (7a) sur la ligne de moteur (2, 3) / d'une force différentielle (14) exercée sur les lignes de moteur (2, 3), dans lequel la ligne de moteur (2, 3) est agencée dans la plage d'entrée d'un aiguillage (10) du système de moteur linéaire à stator long (1).

7. Dispositif selon la revendication 6, dans lequel la ligne de moteur (2, 3) comprend un cadre (4) et au moins stator (5) qui y est monté, dans lequel le dispositif de mesure (15) comprend au moins un capteur de force (16, 17), qui est agencée sur le stator (5) et sur le cadre (4) pour la mesure d'une force d'attraction exercée électromagnétiquement sur le stator (5).

8. Dispositif selon la revendication 6 ou 7, dans lequel la ligne de moteur (2, 3) comprend un cadre (4) et un rail de guidage (6) qui y est monté et le véhicule de transport (7) comporte des galets (9) qui s'étendent latéralement le long de celui-ci, et dans lequel le dispositif de mesure (25) comporte au moins un capteur de force (26, 27), qui est agencé entre le rail de guidage (6) et le cadre (4) pour la mesure d'une force de poussée exercée sur le rail de guidage (6).

9. Dispositif selon l'une des revendications 6 à 8, dans lequel le dispositif de mesure (15, 25) comporte au moins un capteur de force (16, 17, 26, 27) enchâssé entre un cadre (4) de la ligne de moteur (2, 3) et un stator (5) et/ou entre le cadre (4) et un rail de guidage latéral (6) pour le véhicule de transport (7).

10. Dispositif selon l'une des revendications 6 à 9, dans lequel deux lignes de moteur (2, 3) sont constituées avec un dispositif de mesure (15, 25) de part et d'autre du véhicule de transport (7) pour la mesure de deux forces (12, 13, 22, 23) exercées de manière opposée par le véhicule de transport (7) transversalement à sa direction de transport (7a) sur les lignes de moteur (2, 3) ou une force différentielle (14) qui en résulte.

11. Dispositif selon au moins l'une des revendications 6 à 10, dans lequel le dispositif de mesure (15, 25) est agencé dans une section rectiligne de la ligne de moteur (2, 3).

12. Dispositif selon au moins l'une des revendications 6 à 11, dans lequel le dispositif de mesure (15, 25) est constitué pour la mesure d'une force normale latérale.
